# EUROPÄISCHE PATENTANMELDUNG

(11) **EP 0 569 781 A1**
(43) Veröffentlichungstag der Anmeldung: **18.11.1993**
(21) Anmeldenummer: 93106909.0
(22) Anmeldetag: 28.04.1993
(51) Int. Cl.: H01L 39/16, H01L 39/10, H01L 39/22

(54) **Supraleitungseinrichtung mit zwei Leiterstücken aus Hoch-Tc-Supraleitermaterial und dazwischenliegender Übergangszone**

(30) Priorität: 11.05.1992 DE 4215483; 11.05.1992 DE 4215482
(71) Anmelder: SIEMENS AKTIENGESELLSCHAFT, D-80333 München (DE)
(72) Erfinder: Hillenbrand, Bernhard, Dr. Dipl.-Phys., W-8525 Uttenreuth (DE)

(57) **Zusammenfassung**

Die Supraleitungseinrichtung (10) weist zwei Leiterstücke (3a, 3b) aus Hoch-T_{c}- Supraleitermaterial und eine dazwischenliegende Übergangszone (4) mit vorbestimmten supraleitenden Eigenschaften auf. Erfindungsgemäß soll an der Übergangszone (4) mindestens ein Filmstreifen (6) aus einem elektro- oder magnetostriktiven Material vorgesehen sein, mittels dessen in der Übergangszone (4) mechanische Spannungen zur Einstellung der vorbestimmten supraleitenden Eigenschaften in dieser Zone hervorzurufen sind.

## Beschreibung

Die Erfindung bezieht sich auf eine Supraleitungseinrichtung
- mit zwei Leiterstücken aus einem metalloxidischen Supraleitermaterial mit hoher Sprungtemperatur,
und
- mit einer die Leiterstücke verbindenden schmalen Übergangszone mit vorbestimmten supraleitenden Eigenschaften
Eine derartige Supraleitungseinrichtung ist z.B. der DE-C-38 15 183 zu entnehmen.

Supraleitende Metalloxidverbindungen mit hohen Sprungtemperaturen T_{c} von vorzugsweise über 77 K, die deshalb mit flüssigem Stickstoff bei Normaldruck gekühlt werden können, sind allgemein bekannt. Entsprechende Metalloxidverbindungen, bei denen es sich insbesondere um Cuprate handelt, basieren beispielsweise auf einem Stoffsystem des Typs Mel-Me2-Cu-O, wobei die Komponenten Mel ein Seltenes Erdmetall oder Yttrium und Me2 ein Erdalkalimetall zumindest enthalten. Hauptvertreter dieser Gruppe ist das vierkomponentige Stoffsystem Y-Ba-Cu-O (Abkürzung: YBCO). Daneben weisen auch Phasen von fünf- oder höherkomponentigen, seltenerdfreien Cupraten wie z.B. des Stoffsystems Bi-Sr-Ca-Cu-O (Abkürzung: BSCCO) oder Tl-Ba-Ca-Cu-O (Abkürzung: TBCCO) Sprungtemperaturen T_{c} von deutlich über 77 K auf.

Es ist gelungen, mittels spezieller PVD- oder CVD-Prozesse dünne Schichten aus diesen Hochtemperatursupraleiter(HTS)-Materialien herzustellen, die eine hohe kritische Stromdichte (Stromtragfähigkeit) gewährleisten. Man ist deshalb auch bestrebt, mit solchen dünnen Schichten Josephsonkontaktelemente oder steuerbare Supraleitungseinrichtungen, insbesondere transistoranaloge Bauelemente, auszubilden, bei denen der Suprastrom oder allgemein die Kennlinie einer Übergangszone durch eine Spannung oder einen Strom bzw. durch ein elektrisches oder magnetisches Feld fest eingestellt oder gesteuert wird. Hierbei tritt jedoch im Gegensatz zu den konventionellen metallischen Supraleitermaterialien, die mit flüssigem Helium gekühlt werden müssen, die Problematik auf, daß die bekannten metalloxidischen HTS-Materialien nur eine kurze Kohärenzlänge und eine starke Anisotropie aufweisen.

Die kurze Kohärenzlänge führt dazu, daß auch kleine Störungen im HTS-Material wie z.B. Gitterstörungen oder Sauerstoffehlstellen starke lokale Störungen der Supraleitung verursachen. Daher lassen sich Josephsonkontakte, deren Längendimension von der Größe der Kohärenzlänge sind, schon durch Gefügestörungen herstellen, wie sie eine ausscheidungsfreie Korngrenze darstellt. Jedoch sind die Eigenschaften entsprechender Korngrenzen wegen der Abhängigkeit der Supraleitung von punktuellen Störungen nur schwer reproduzierbar einzustellen und außerdem nur schlecht zu variieren. Nach konventionellen Methoden, z.B. durch eine etwa 1 bis 10 nm dicke Isolatorschicht, lassen sich mit HTS-Materialien keine Josephsonkontakte erhalten.

Es sind verschiedene Verfahren vorgeschlagen worden, um gezielt Korngrenzen für Josephsonkontaktelemente zu erzeugen. So soll z.B. bei einem mit der EP-A-O 364 101 vorgeschlagenen Kontaktelement die Tatsache ausgenutzt werden, daß Dünnfilme aus metalloxidischem HTS-Material mit einer senkrechten Ausrichtung der c-Kristallachsen bezüglich der Filmebene über eine hinreichend flache Unebenheit einer Substratoberfläche störungsfrei hinwegwachsen können, jedoch an steileren Flanken von besonderen Störstrukturen Korngrenzen ausbilden. Dementsprechend ist bei dem vorgeschlagenen Kontaktelement auf einem ebenen Substrat in einer Zone, wo der eigentliche Josephsonkontakt entstehen soll, der sogenannten Josephsonkontaktzone, eine den Kristallaufbau des Substrates störende gratartige Erhebung mit einem mittleren Scheitelbereich zwischen zwei seitlichen Flanken abgeschieden. Diese Flanken grenzen im Scheitelbereich mit hinreichend hoher Steilheit aneinander, während sie an ihren Rändern zumindest weitgehend stoßfrei in die Substratebene übergehen. Wenn dann auf einem derartigen Aufbau epitaktisch ein HTS-Dünnfilm aufwächst, so wird in diesen Film in dem Scheitelbereich eine abrupte Änderung der Kristallorientierung in Form einer Korngrenze eingebaut. Die die eigentliche Josephsonkontaktzone bildende Korngrenze stellt eine Schwachstelle dar, in der die elektrischen Eigenschaften (insbesondere die kritische Stromdichte) deutlich schlechter sind. Eine sich über diesen Scheitelbereich hinwegstreckende Leiterbahn zerfällt so in zwei HTS-Leiterstücke, die gute supraleitende Eigenschaften aufweisen und die über die Schwachstelle der Josephsonkontaktzone miteinander verbunden sind.

Weitere Formen der gezielten Erzeugung von Korngrenzen mit Josephsoneigenschaften sind beispielsweise unter der Bezeichnung "step edge junction", "edge junction" oder "Bikristall-Junction" allgemein bekannt (vgl. z.B. den Preprint des Beitrags von R. Gross und P. Chaudhari mit dem Titel "Status of dc-SQUIDs in the High Temperature Superconductors" in "Principles and Applications of Superconducting Quantum Interference Devices", Hrsg.: A. Barone, Verlag World Scientific, Singapore 1991).

Aus der eingangs genannten DE-C ist ein steuerbares supraleitendes Gatterelement zu entnehmen, das z.B. als ein Verknüpfungsglied in einer logischen Schaltung dienen kann. Dieses Element enthält zwei in getrennten Ebenen eines gestuften Substrates liegende Leiterstücke aus texturiertem HTS-Material. Diese Leiterstücke sind miteinander mittels einer durch eine texturierte HTS-Schicht gebildete Übergangszone verbunden, die an der senkrecht zu den beiden Ebenen der Leiterstücke ausgerichteten Seitenfläche der Stufe anliegt. Über diese Übergangszone ist eine Steuerleitung in Form einer streifenförmigen Leiterbahn aus normalleitendem Material hinweggeführt, mit der ein steuerndes Magnetfeld aufgrund eines entsprechenden Steuerstromes zu erzeugen ist. Der durch dieses Magnetfeld hervorgerufene magnetische Fluß in der Übergangszone beeinflußt den somit steuerbaren Spannungsabfall über der Übergangszone. Eine solche Steuerung läßt sich mit äußerst geringer Schaltzeit durchführen. Der präparative Aufwand zur Herstellung eines entsprechenden Elementes auf einem gestuften Substrat ist jedoch verhältnismäßig hoch.

Aufgabe der vorliegenden Erfindung ist es, die Supraleitungseinrichtung mit den eingangs genannten Merkmalen dahingehend auszugestalten, daß diese bei den bekannten Einrichtungen gegebenen herstellungstechnischen Schwierigkeiten zumindest verringert sind. Hierbei sollen nicht Strukturen mit Abmessungen in Stromführungsrichtung von unter 1 nm, wie sie für Ausführungsformen von bekannten Josephsonkontaktelementen für erforderlich gehalten werden, sondern Strukturen mit Abmessungen im µm-Bereich verwendet werden können. Zugleich soll eine verhältnismäßig einfache Möglichkeit zur Einstellung der supraleitenden Eigenschaften der Übergangszone gegeben sein.

Diese Aufgabe wird erfindungsgemäß dadurch gelöst, daß mindestens ein Filmstreifen aus einem Material mit hinreichender Elektro- oder Magnetostriktion vorgesehen ist, mittels dessen in der Übergangszone mechanische Spannungen zur Einstellung der vorbestimmten supraleitenden Eigenschaften dieser Zone hervorzurufen sind. Physikalisch wirksam sind dabei selbstverständlich die mit den mechanischen Spannungen verbundenen Dehnungen oder Stauchungen bzw. Atomabstandsänderungen.

Bei dieser Ausgestaltung der Supraleitungseinrichtung wird die an sich bekannte Tatsache ausgenutzt, daß die supraleitenden Eigenschaften bei Leitern aus Hoch-T-Cupraten von mechanischen Spannungen abhängen, die auf diese Leiter einwirken (vgl. z.B. "Phys. Rev. B", Vol. 44, No. 18, 1.11.1991 - II, Seiten 10117 bis 10120). Die mit den erfindungsgemäßen Maßnahmen verbundenen Vorteile sind insbesondere darin zu sehen, daß sich die Polarisation bzw. Magnetisierung des elektro-bzw. magnetostriktiven Filmstreifens sehr genau und einfach einstellen läßt und damit entsprechend gut definierte Druck- oder Zugspannungen in der Übergangszone auszuüben sind. Diese mechanischen Spannungen beeinflussen in entsprechender Weise die Kennlinie, insbesondere den Suprastrom, in diesem Bereich. Die Übergangszone braucht dabei nicht unbedingt von vornherein zwischen zwei Leiterstücken aus dem HTS-Material ausgebildet gewesen zu sein. Vielmehr besteht vorteilhaft auch die sehr einfache Möglichkeit, erst mit Hilfe des elektro- oder magnetostriktiven Filmstreifens in einer zunächst durchgehenden supraleitenden Leiterbahn mittels der auf eine wählbare schmale Zone einwirkenden einstellbaren Kräfte dort einstellbare supraleitende Eigenschaften zu erhalten. In einem solchen Falle wird die zunächst durchgehende supraleitende Leiterbahn erst durch den von dem elektro- oder magnetostriktiven Filmstreifen erzeugten Bereich mechanischer Spannungen in die beiden Leiterstücke unterteilt, wobei dieser Bereich mechanischer Spannungen die Übergangszone zwischen diesen Leiterstücken bildet. Mit den erfindungsgemäßen Maßnahmen können also vorteilhaft supraleitende Einrichtungen mit einstellbaren Iransistorfunktionen in elektrischen Schaltungen, insbesondere mit Schaltfunktionen, oder Josephsonkontaktelemente bzw. SQUIDs mit wohldefinierten elektrischen Eigenschaften ihrer Übergangs- oder Kontaktzonen ausgebildet werden. Hierbei besteht grundsätzlich auch die Möglichkeit, auf einem beispielsweise ebenen Substrat beliebig viele derartiger Supraleitungseinrichtungen an weitgehend frei wählbaren Stellen z.B. in Form eines Arrays auszubilden.

Vorteilhafte Ausgestaltungen der erfindungsgemäßen Supraleitungseinrichtung gehen aus den abhängigen Ansprüchen hervor.

Die Erfindung wird nachfolgend anhand von Ausführungsbeispielen noch weiter erläutert, wobei auf die schematische Zeichnung Bezug genommen wird. Dabei zeigen die Figuren 1 und 2 als Längsschnitt bzw. in Schrägansicht den prinzipiellen Aufbau einer erfindungsgemäßen Supraleitungseinrichtung. Aus dem Längsschnitt der Figur 3 geht eine weitere prinzipielle Ausführungsform einer erfindungsgemäßen Supraleitungseinrichtung hervor. Figur 4 zeigt als Schrägansicht einen Aufbau mit einer anderen Supraleitungseinrichtung. In Figur 5 ist als Aufsicht eine spezielle Ausführungsform einer Supraleitungseinrichtung dargestellt.

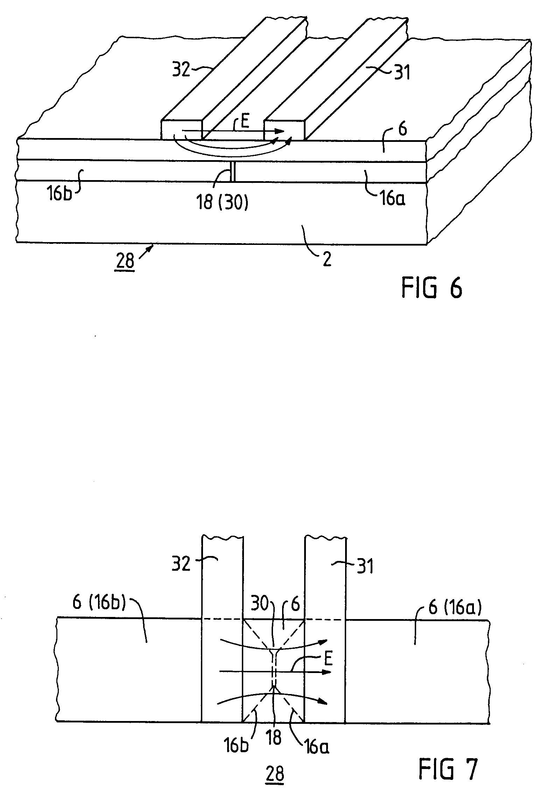

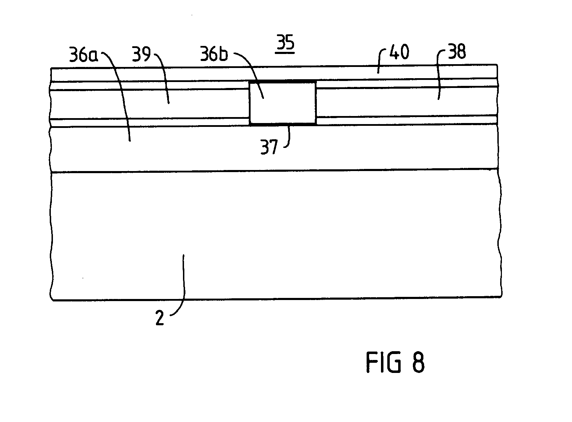

In den Figuren 6 und 7 ist eine weitere Supraleitungseirichtung in Schrägansicht bzw. als Aufsicht angedeutet. Aus dem Längsschnitt der Figur 8 ist eine andere Ausführungsmöglichkeit für eine erfindungsgemäße Supraleitungseinrichtung zu entnehmen. In den Figuren sind sich entsprechende Teile mit denselben Bezugszeichen versehen.

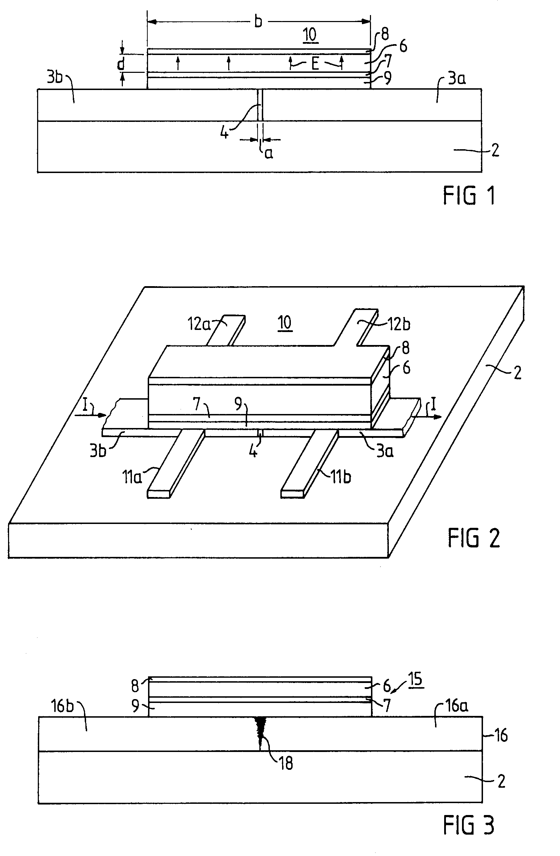

Gemäß den Figuren 1 und 2 sind auf einem beispielsweise ebenen Substrat 2 in Dünnfilmtechnik zwei Leiterstücke 3a und 3b aus einem der bekannten HTS-Materialien wie z.B. YBCO oder BSCCO mit einer Sprungtemperatur T_{c} von vorzugsweise über 77 K aufgebracht. Als Substrat wird dabei insbesondere ein Träger aus einem Material vorgesehen, auf dem das gewählte HTS-Material nach bekannten Verfahren epitaktisch aufwachsen kann. So kommt als Substrat insbesondere SrTiO₃ oder MgO in Frage. Auch Si-Substrate mit einem diffusionshemmenden Überzug, einer sogenannten "Bufferlayer", sind geeignet. Gemäß dem dargestellten Ausführungsbeispiel sind die beiden supraleitenden Leiterstücke 3a und 3b von vornherein in einer sehr schmalen Übergangszone 4 durch eine Sollschwachstelle voneinander getrennt. Die Ausdehnung a dieser Zone in Richtung eines zu führenden Stromes I (vgl. Figur 2) liegt vorzugsweise zwischen 0,2 und 1 nm. Eine entsprechende Sollschwachstelle kann insbesondere durch eine Korngrenze oder durch eine räumliche Einschnürung oder durch eine sonstige Formgebung zu einer mechanischen Spannungskonzentration ausgebildet sein. Die Übergangszone 4 zeichnet sich prinzipiell dadurch aus, daß in ihr die ansonsten in den supraleitenden Leiterstücken 3a und 3b gegebenen guten supraleitenden Leitereigenschaften wie insbesondere die kritische Stromdichte vergleichsweise deutlich verschlechtert sind.

Erfindungsgemäß soll nun über dieser Sollschwachstelle, beispielsweise quer zur Hauptausbreitungsrichtung der supraleitenden Leiterstücke 3a und 3b, mindestens ein dünner Filmstreifen aus einem besonderen Material liegen, wobei der Streifen mit dem Untergrund der Übergangszone 4 und/oder mit den daran angrenzenden Enden der Leiterstücke 3a und 3b fest, d.h. kraftschlüssig, verbunden ist. Die Abmessung (hier: die Breite) b dieses Filmstreifens in Stromführungsrichtung der Leiterstücke kann vorteilhaft in der Größenordnung von 1 bis 10 µm liegen. Als Materialien für den Filmstreifen sind elektrostriktive oder magnetostriktive Werkstoffe geeignet, die sich bei den gewählten Betriebsbedingungen der Supraleitungseinrichtung durch einen verhältnismäßig großen Elektrostriktionskoeffizienten Q oder durch einen verhältnismäßig großen Magnetostriktionskoeffizienten λ auszeichnen. Unter einem elektrostriktiven Material sei hierbei ein Werkstoff verstanden, der quadratisch und/oder linear bezüglich der elektrischen Polarisation ist. Werkstoffe mit ausgeprägt quadratischem Effekt werden vielfach auch als die eigentlichen elektrostriktiven Werkstoffe angesehen. Demgegenüber handelt es sich bei Werkstoffen mit ausgeprägt linearem Effekt insbesondere um piezoelektrische Materialien, genauer: um Materialien mit reziprokem piezoelektrischen Effekt (vgl. z.B. "Enzyklopädie Naturwissenschaft und Technik", Verlag Moderne Industrie, 1980, Seite 1113). Dieser Effekt kann in speziellen ferroelektrischen Materialien besonders groß sein. Vorzugsweise werden als elektrostriktive Materialien Werkstoffe verwendet, deren Betrag des Wertes des Elektrostriktionskoeffizienten Q bei einer Temperatur von etwa 77 K über |1 * 10⁻² m⁴C⁻²| liegt. Beispiele für entsprechende Materialien, die diese Forderung erfüllen können, sind spezielle Perowskite wie SrTiO₃, BaTiO₃ oder Pb(Mg_{0,33}Nb_{0,67})O₃ (vgl. z.B. "Journ. of. Mat. Sci.", Vol. 16, 1981, Seiten 569 bis 578 oder "Jap. Journ. of Appl. Phys.", Vol. 19, No. 11, Nov. 1980, Seiten 2099 bis 2103). Materialien mit Perowskitstruktur haben außerdem den Vorteil, daß sie sich ohne Störung der Kristallstruktur des HTS-Materials auf entsprechend strukturierten Unterlagen gut haftend aufbringen lassen.

Piezoelektrische Materialien als Spezialfall der elektrostriktiven Materialien sind allgemein bekannt (vgl. z.B. "Advanced Materials", Vol. 2, No. 10, 1990, Seiten 458 bis 463). Als Beispiele für Materialien, die besonders gut an HTS-Materialien angepaßt sind, seien Mischkristalle des BaTiO₃ oder Pb(Zr,Ti)O₃ genannt. Dabei ist es möglich, durch Substitution einzelner Elemente dieser Materialien deren Eigenschaften, etwa die Gitterkonstante oder die Ordnungstemperaturen bei Ferroelektrika, an spezifische Anforderungen anzupassen. Die typische Größenordnung der piezoelektrischen Konstanten liegt bei 10⁻⁹ bis 10⁻¹⁰ m/V.

Statt Materialien mit ausgeprägter Elektrostriktion sind ebensogut auch magnetostriktive Werkstoffe geeignet, deren Betrag des Wertes des Magnetostriktionskoeffizienten λ bei einer Temperatur von etwa 77 K mindestens |5 * 10⁻⁶| beträgt, vorzugsweise über |20 * 10⁻⁶| liegt. Diese Forderung erfüllen z.B. Legierungen aus Seltenen Erden und Übergangsmetallen. So hat der Magnetostriktionskoeffizient λ z.B. für Pr₂Co₁₇ einen Wert von über |300 * 10⁻⁶| (vgl. z.B. das Buch "Ferromagnetic Materials", Vol. 1, Hrsg.: E.P. Wohlfarth, North-Holland Pub. Co., Amsterdam 1980, Seiten 540 bis 552). Auch die sogenannten "Terfenole" sind besonders geeignet (vgl. z.B. "Mikroelektronik", Band 4, Heft 6, 1990, Fachbeilage "Mikroperipherik", Seiten XCII bis XCVI).

Für das in den Figuren 1 und 2 dargestellte Ausführungsbeispiel sei ein Filmstreifen 6 aus einem elektrostriktiven, vorzugsweise piezoelektrischen Material wie z.B. aus BaTiO₃ ausgewählt. Dieser Filmstreifen hat z.B. eine Dicke d zwischen 0,1 und 5 µm. Er kann in der Übergangszone 4 bzw. Sollschwachstelle einem elektrischen Feld E ausgesetzt werden. Dieses durch gepfeilte Linien angedeutete Feld E wird mittels zweier schichtartiger Metallelektroden 7 und 8 hervorgerufen, zwischen denen sich der Filmstreifen 6 befindet. Dabei ist die den supraleitenden Leiterstücken 3a und 3b zugewandte, untere Elektrode 7 gegenüber diesen Leiterstücken 3a und 3b durch eine dünne Isolatorschicht 9 isoliert. Die an den Elektroden 7 und 8 anzulegende elektrische Spannung sollte möglichst klein sein und im Idealfall unter der sogenannten Gap-Spannung liegen. Wird nun ein solcher Filmstreifen 6 dem elektrischen Feld E ausgesetzt, so ändert er entsprechend seiner Elektrostriktion seine Abmessungen und setzt so die mit ihm verbundene, unter ihm angeordnete Übergangszone 4 je nach Vorzeichen der Elektrostriktion unter entsprechende Druck- bzw. Zugspannungen. Gegebenenfalls ist es auch möglich, mehrere Filmstreifen 6 sandwichartig zu einem Paket anzuordnen, um so zu einer Verstärkung der Kraftwirkung zu gelangen. Bei den erzeugten Druck- oder Zugspannungen wird gemäß dem in den Figuren 1 und 2 dargestellten Ausführungsbeispiel ein Quereffekt ausgenutzt. Zwar wird durch das Feld E zunächst beispielsweise eine Dehnung in Richtung der Hauptausdehnungsrichtung des Filmstreifens bewirkt. Damit verbunden ist aber auch eine Querkontraktion, die eine entsprechende Kompression der Übergangszone in dieser Querrichtung hervorruft. Diese mechanischen Spannungen führen dann zu einer entsprechenden Änderung der supraleitenden Eigenschaften, insbesondere des Suprastroms bzw. der kritischen Stromdichte, in der Zone 4, die deshalb als eine Schwachstelle anzusehen ist. Diese Änderung kann durch Variation der an dem Filmstreifen 6 anzulegenden Feldverhältnisse entsprechend beeinflußt und gegebenenfalls sogar gesteuert werden. Dabei sollten die gegebenen Elastizitätsgrenzen der einzelnen Schichten im allgemeinen nicht überschritten werden. Auf diese Weise ist es möglich, die Übergangszone 4 als eine Schwachstelle mit in Abhängigkeit von der jeweiligen Anwendung wählbarer Einstellung der Sollwerte der elektrischen Parameter auszubilden. Die Einstellung der Sollwerte kann dabei steuerbar sein. Daneben lassen sich die Sollwerte auch einmalig fest vorgeben, um insbesondere eine Kontaktzone eines Josephsonkontaktelementes zu erzeugen. Der entsprechende Einstelleffekt kann dabei durch besondere Formgebung der Übergangszone, beispielsweise mittels einer Querschnittseinengung, noch weiter verstärkt werden. Die so entstandene Supraleitungseinrichtung ist in den Figuren 1 und 2 allgemein mit 10 bezeichnet.

Aus der Darstellung der Supraleitungseinrichtung 10 in der Figur 2 sind ferner noch zwei Spannungsabgriffe 11a und 11b an den der gemeinsamen Übergangszone 4 zugewandten Enden der supraleitenden Leiterstücke 3a und 3b ersichtlich. Außerdem sind zwei Anschlußstücke 12a und 12b für die an die untere Metallelektrode 7 und die obere Metallelektrode 8 anzulegende Spannung angedeutet.

Abweichend von der in Figur 1 dargestellten Ausführungsform einer beispielsweise steuerbaren Supraleitereinrichtung 10 kann gemäß dem ebenfalls als Längsschnitt veranschaulichten Ausführungsbeispiel nach Figur 3 eine Übergangszone bzw. ein Schwachstellenbereich einer entsprechenden Supraleitungseinrichtung 15 auch erst mit Hilfe des elektrostriktiven Filmstreifens 6 erzeugt werden. Dementsprechend wird nach Figur 3 auf dem Substrat 2 zunächst eine durchgehende Leiterbahn 16 aus dem HTS-Material erstellt. Anschließend wird am Ort der auszubildenen Übergangszone der Filmstreifen 6 mit den Metallelektroden 7 und 8 sowie mit der Isolatorschicht 9 gemäß Figur 1 aufgebracht. Aufgrund der elektro-striktiven Eigenschaften dieses Streifens wird in der darunterliegenden supraleitenden Leiterbahn 16 ein Bereich mechanischer Spannungen hervorgerufen. Dieser Bereich stellt dann die gewünschte, in der Figur nur schematisch veranschaulichte und mit 18 bezeichnete Übergangszone mit zum Beispiel steuerbarer Einstellung der elektrischen Eigenschaften der Supraleitungseinrichtung 15 dar. Die Übergangszone 18 kann auch eine Kontaktzone mit Weak-Link-Eigenschaften eines Josephsonkontaktelements sein. Die Zone 18 unterteilt somit die supraleitende Leiterbahn 16 in zwei Leiterstücke 16a und 16b. Für die Ausführungsformen nach Figur 3 ist es besonders vorteilhaft, wenn im Bereich der auszubildenden Supraleitungseinrichtung 15 die Leiterbahn 16 von vornherein eine Querschnittsverminderung bzw. Verengung aufweist.

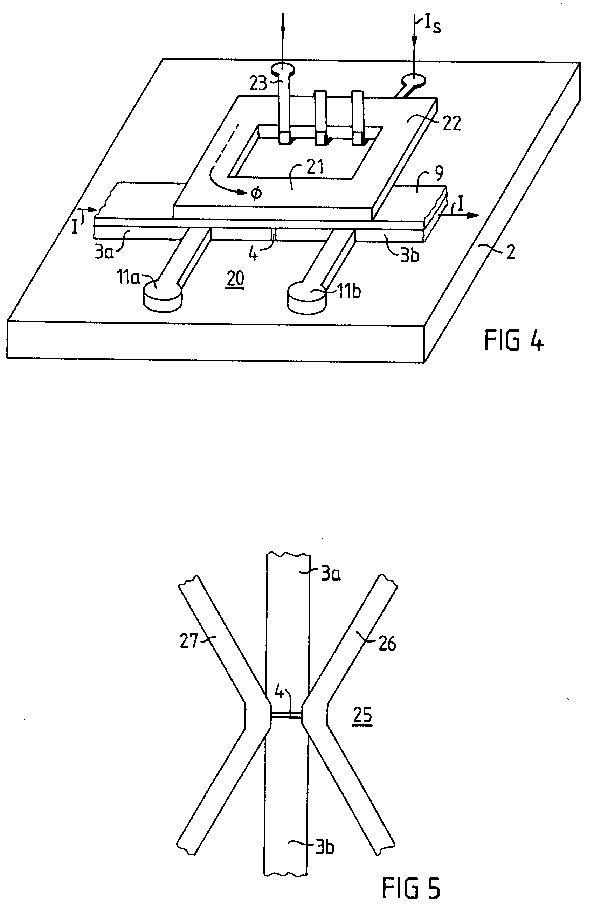

Bei den Ausführungsformen von erfindungsgemäßen Supraleitungseinrichtungen 10 und 15 nach den Figuren 1 bis 3 wurde davon ausgegangen, daß der die mechanischen Spannungen verursachende mindestens eine Filmstreifen 6 aus einem elektrostriktiven, insbesondere piezoelektrischen Material besteht. Eine entsprechende Wirkung eines Filmstreifens kann jedoch ebensogut auch aufgrund einer hinreichenden Magnetostriktion des Materials mindestens eines entsprechenden Filmstreifens erreicht werden. Hierbei läßt sich ein steuerndes Magnetfeld z.B. mit supraleitenden Leiterbahnen verlustfrei anlegen; jedoch muß man die Supraleitungseinrichtung vor dem Streufeld des magnetostriktiven Materials und dem Feld des Steuerstroms schützen. Eine Ausführungsform mit einem magnetostriktiven Filmstreifen als Teil eines geschlossenen Magnetkreises, bei der das erregende Feld hinreichend weit von der Übergangszone entfernt ist und das Streufeld aufgrund einer geschlossenen Bauform des Magnetkreises weitgehend unterdrückt wird, ist aus der Schrägansicht der Figur 4 ersichtlich. Dabei wurde auf eine Darstellung von eventuell noch erforderlichen Abschirmungen verzichtet. In der Figur ist, abweichend von der Darstellung der Figur 2, für eine Supraleitungseinrichtung 20 ein über deren Übergangszone 4 isoliert hinweglaufender Filmstreifen 21 aus einem magnetostriktiven Material vorgesehen. Dieser Filmstreifen ist außerhalb des Bereichs der Übergangszone 4 zu einer in sich geschlossenen Leiterschleife 22 ausgebildet. In dem von der Übergangszone entferntesten Bereich dieser Leiterschleife ist um den Filmstreifen eine Spule 23 angeordnet, durch die mittels eines Steuerstromes Iₛ in der Leiterschleife ein magnetischer Fluß φ hervorzurufen ist. Dieser Fluß führt zu der angestrebten Magnetostriktion des Filmstreifens 21 insbesondere auch im Bereich der Übergangszone 4.

Bei den Ausführungsformen von gegebenenfalls steuerbaren Supraleitungseinrichtungen 10, 15 und 20 nach den Figuren 1 bis 4 wurde davon ausgegangen, daß in den Übergangszonen 4 bzw. 18 die mechanischen Spannungen jeweils von einem einzigen, über die jeweilige Übergangszone hinweglaufenden Filmstreifen aus einem elektro- oder magnetostriktiven Material hervorzurufen sind. Selbstverständlich ist es ebensogut möglich, entsprechende Kräfte auf eine Übergangszone auch mit Hilfe von zwei, z.B. zu beiden Seiten dieser Zone verlaufenden und an diese Zone angrenzenden elektro- oder magnetostriktiven Filmstreifen auszuüben. Ein entsprechendes Ausführungsbeispiel geht aus der Aufsicht der Figur 5 hervor. Wie bei der Ausführungsform nach Figur 1 sind bei dieser allgemein mit 25 bezeichneten, gegebenenfalls steuerbaren oder ein Josephsonkontaktelement bildenden Supraleitungseinrichtung zwei supraleitende Leiterstücke 3a und 3b über eine Sollschwachstelle einer Übergangszone 4 miteinander verbunden. In diesem Bereich grenzen an die gegenüberliegenden Schmalseiten der Schwachstelle jeweils Stücke von elektro- oder magnetostriktiven Filmstreifen 26 bzw. 27 an, mit denen gemeinsam die gewünschten mechanischen Spannungen in dem Schwachstellenbereich zu erzeugen sind. Diese Filmstreifenstücke können die supraleitenden Leiterstücke 3a und 3b einschließlich ihrer gemeinsamen Übergangszone 4 auch teilweise überlappen.

Die erfindungsgemäßen Maßnahmen sind auch nicht auf eine elastische Verformung eines Schwachstellenbereiches mittels eines elektro- oder magnetostriktiven Filmstreifens beschränkt. Gegebenenfalls kann mit mindestens einem solchen Filmstreifen auch eine plastische Verformung bewirkt werden. In den Figuren 6 und 7 ist ein entsprechendes Ausführungsbeispiel einer allgemein mit 28 bezeichneten, erfindungsgemäßen Supraleitungseinrichtung in Schrägansicht bzw. als Aufsicht angedeutet. Dabei sei eine Ausführungsform mit zunächst durchgehender supraleitender Leiterbahn 16 entsprechend Figur 3 zugrundegelegt. Diese Leiterbahn sei mit einer Verengung 30 versehen (vgl. Figur 7). Die Leiterbahn ist zumindest im Bereich dieser Verengung mit einem z.B. elektrostriktiven Filmstreifen 6 abgedeckt. Zu beiden Seiten des Verengungsbereiches sind auf den Filmstreifen zwei Elektroden 31 und 32 querverlaufend angebracht. Eine an diese Elektroden angelegte Spannung ruft ein elektrisches Feld E hervor, das beispielsweise eine Dehnung des Filmstreifens 6 bewirkt. Die damit auf die darunterliegende Leiterbahn 16 ausgeübten mechanischen Spannungen können so groß sein, daß sie eine plastische Verformung der Leiterbahn insbesondere im Bereich der Verengung 30, gegebenenfalls sogar ein Auf- oder Auseinanderreißen (unter Ausbildung eines Mikrorisses) in diesem Bereich, zur Folge haben. Durch ein Umpolen des elektrischen Feldes E können dann mechanische Spannungen in umgekehrter Richtung hervorgerufen werden, die zu einer Pressung bzw. zu einem Preßkontakt im Bereich der Verengung 30 und damit zur Ausbildung einer Übergangszone 18 gemäß Figur 3 führen.

Die Anordnung gemäß den Figuren 6 und 7 kann selbstverständlich auch im elastischen Bereich betrieben werden, nachdem einmal die Schwachstelle im Bereich der Verengung 30 erzeugt ist.

Eine weitere Ausführungsführungsform einer steuerbaren Supraleitungseinrichtung mit zwei elektro- oder magnetostriktiven Filmstreifen ist der Figur 8 zu entnehmen. Die als Schnitt veranschaulichte, allgemein mit 35 bezeichnete Einrichtung kann z.B. ein Schaltelement einer Schaltmatrix darstellen, die ein ganzes Array solcher Elemente umfaßt. Auf einem Substrat 2 erstreckt sich ein erstes (unteres) Leiterstück 36a aus HTS-Material, das von einem entsprechendem zweiten (oberen) Leiterstück 36b gekreuzt wird. Im Kreuzungsbereich ist zwischen diesen beiden Leiterstücken als eine Übergangszone 37 eine Sollschwachstelle ausgebildet. Diese Sollschwachstelle ist in der Figur durch eine verstärkte Linie angedeutet. Das obere, zweite Leiterstück 36b ist im Bereich dieser Sollschwachstelle zwischen zwei Steuerleitungen kraftschlüssig angeordnet. Diese Steuerleitungen sind jeweils durch einen Aufbau gemäß Figur 1 oder 2 mit Filmstreifen 38 und 39 aus elektro- oder magnetostriktivem Material ausgebildet. Die erforderlichen Metallelektroden sind in Figur 8 nicht näher ausgeführt. Mittels dieser Filmstreifen können in der Übergangszone 37 wie bei einem Preßkontakt mechanische Spannungen erzeugt werden, die die Kennlinie der Schwachstelle entsprechend beeinflussen und damit die Schaltfunktion bewirken. Der in der Figur gezeigte Aufbau ist noch üblicherweise mit einer isolierenden Deckschicht 40 überzogen.

## Patentansprüche

1. Supraleitungseinrichtung
- mit zwei Leiterstücken aus einem metalloxidischen Supraleitermaterial mit hoher Sprungtemperatur,
- mit einer die Leiterstücke verbindenden schmalen Übergangszone mit vorbestimmten supraleitenden Eigenschaften
und
- mit mindestens einem Filmstreifen (6; 21; 26, 27; 38, 39) aus einem Material mit hinreichender Elektro- oder Magnetostriktion, mittels dessen in der Übergangszone (4, 18, 37) mechanische Spannungen zur Einstellung der vorbestimmten supraleitenden Eigenschaften dieser Zone hervorzurufen sind.

2. Einrichtung nach Anspruch 1, **gekennzeichnet durch** ein Material des mindestens einen Filmstreifens (21; 26, 27; 38, 39) mit einem Magnetostriktionskoeffizienten λ, für den gilt: λ ≧ |5 * 10⁻⁶| .

3. Einrichtung nach Anspruch 1, **gekennzeichnet durch** ein Material des mindestens einen Filmstreifens (6; 26, 27; 38, 39) mit einem Elektrostriktionskoeffizienten Q, für den gilt: Q ≧ |1 * 10⁻² m⁴C⁻²| .

4. Einrichtung nach einem der Ansprüche 1 bis 3, **dadurch gekennzeichnet,** daß die Übergangszone (4) an einer bereits vorhandenen Schwachstelle mit gegenüber den angrenzenden supraleitenden Leiterstücken (3a, 3b; 36a, 36b) verminderten supraleitenden Eigenschaften ausgebildet ist.

5. Einrichtung nach Anspruch 4, **dadurch gekennzeichnet,** daß die Schwachstelle durch eine Korngrenze oder mittels besonderer Formgebung erzeugt ist.

6. Einrichtung nach einem der Ansprüche 1 bis 3, **dadurch gekennzeichnet,** daß die Übergangszone (18) zwischen den supraleitenden Leiterstücken (16a, 16b) erst mittels der von dem mindestens einen Filmstreifen (6) aus dem elektro- oder magnetostriktiven Material hervorgerufenen mechanischen Spannungen in einer zunächst durchgehenden supraleitenden Leiterbahn (16) ausgebildet ist.

7. Einrichtung nach Anspruch 6, **dadurch gekennzeichnet,** daß die supraleitende Leiterbahn (16) im Bereich der Übergangszone (18) eine Verengung (30) aufweist.

8. Einrichtung nach Anspruch 6 oder 7, **dadurch gekennzeichnet,** daß die supraleitende Leiterbahn (16) im Bereich der Übergangszone (18) aufgrund der mechanischen Spannungen plastisch verformt ist und/oder einen Mikroriß aufweist.

9. Einrichtung nach einem der Ansprüche 1 bis 8, **gekennzeichnet durch** zwei Filmstreifen (26, 27; 38, 39) aus dem elektro- oder magnetostriktiven Material, zwischen denen sich die Übergangszone (4, 37) erstreckt.

10. Einrichtung nach einem der Ansprüche 1 bis 9, **dadurch gekennzeichnet,** daß Mittel zu einer steuerbaren Einstellung der supraleitenden Eigenschaften der Übergangszone (4, 18, 37) vorgesehen sind, wobei der mindestens eine Filmstreifen (6, 21, 26, 27, 38, 39) als Steuerleitung dient.

11. Einrichtung nach Anspruch 10, **gekennzeichnet durch** eine Anordnung als ein Schaltelement in einem Array einer Schaltmatrix.

12. Einrichtung nach einem der Ansprüche 1 bis 9, **dadurch gekennzeichnet,** daß die Übergangszone (4, 18, 37) eine Josephsonkontaktzone eines Josephsonkontaktelementes ist.
